# EUROPEAN PATENT APPLICATION

(11) **EP 4 191 692 A1**
(43) Date of publication of application: **07.06.2023**
(21) Application number: 21849083.7
(22) Date of filing: 27.07.2021
(51) Int. Cl.: H01L 33/60, F21V 19/00, F21V 23/00, H01L 33/50, H01L 33/62, F21Y 115/10

(54) **LIGHT EMITTING DEVICE AND ILLUMINATION DEVICE**

(30) Priority: 31.07.2020 JP 2020131142
(71) Applicant: Kyocera Corporation, Kyoto-shi Kyoto 612-8501 (JP)
(72) Inventor: KUSANO, Tamio, Kyoto-shi, Kyoto 612-8501 (JP)
(74) Representative: Viering, Jentschura & Partner mbB Patent- und Rechtsanwälte
(86) International application number: PCT/JP2021/027764
(87) International publication number: WO 2022/025065

(57) **Abstract**

A light emitting device includes a substrate on which a feed line and a feed pad are electrically connected to each other; a reflective layer disposed on the feed line and configured to cover at least part of the feed line; a light emitting element electrically connected to the feed line, with the feed pad therebetween, and configured to emit exciting light; and a wavelength conversion member disposed on the light emitting element and configured to convert the exciting light into illuminating light. The light emitting element is disposed on the feed pad electrically connected to the light emitting element, and covers the feed pad in see-through plan view of the substrate.

## Description

This application claims priority to Japanese Patent Application No. 2020-131142 (filed on July 31, 2020), the entire disclosure of which is incorporated herein by reference.

### TECHNICAL FIELD

The present disclosure relates to a light emitting device and an illuminating apparatus.

### BACKGROUND OF INVENTION

A known light emitting device includes a reflective layer on a surface of a substrate on which light emitting elements are mounted (see, e.g., Patent Literature 1).

### CITATION LIST

### PATENT LITERATURE

Patent Literature 1: Japanese Unexamined Patent Application Publication No. 2013-153069

### SUMMARY

In an embodiment of the present disclosure, a light emitting device includes a substrate, a reflective layer, a light emitting element, and a wavelength conversion member. The substrate has thereon a feed line and a feed pad electrically connected to each other. The reflective layer is disposed on the feed line and configured to cover at least part of the feed line. The light emitting element is electrically connected to the feed line, with the feed pad therebetween, and is configured to emit exciting light. The wavelength conversion member is disposed on the light emitting element and configured to convert the exciting light into illuminating light. The light emitting element is disposed on the feed pad electrically connected to the light emitting element, and covers the feed pad in see-through plan view of the substrate.

In another embodiment of the present disclosure, an illuminating apparatus includes at least one light emitting device.

### BRIEF DESCRIPTION OF THE DRAWINGS

FIG. 1 is a perspective view illustrating an exemplary configuration of a light emitting device according to an embodiment;
FIG. 2 is a cross-sectional view taken along line A-A of FIG. 1;
FIG. 3 is a see-through plan view of the light emitting device illustrated in FIG. 1;
FIG. 4 is an enlarged view of an area enclosed by a dash-dot line in FIG. 3;
FIG. 5 is a cross-sectional view illustrating an exemplary configuration of a substrate to which a light emitting element is mounted by flip chip bonding;
FIG. 6 is a plan view of an exemplary configuration where the light emitting element is greater than feed pads;
FIG. 7 is a plan view of an exemplary configuration where a reflective layer covers the substrate; and
FIG. 8 is a perspective view illustrating an exemplary configuration of an illuminating apparatus according to an embodiment.

### DESCRIPTION OF EMBODIMENTS

### (Exemplary configuration of light emitting device 10)

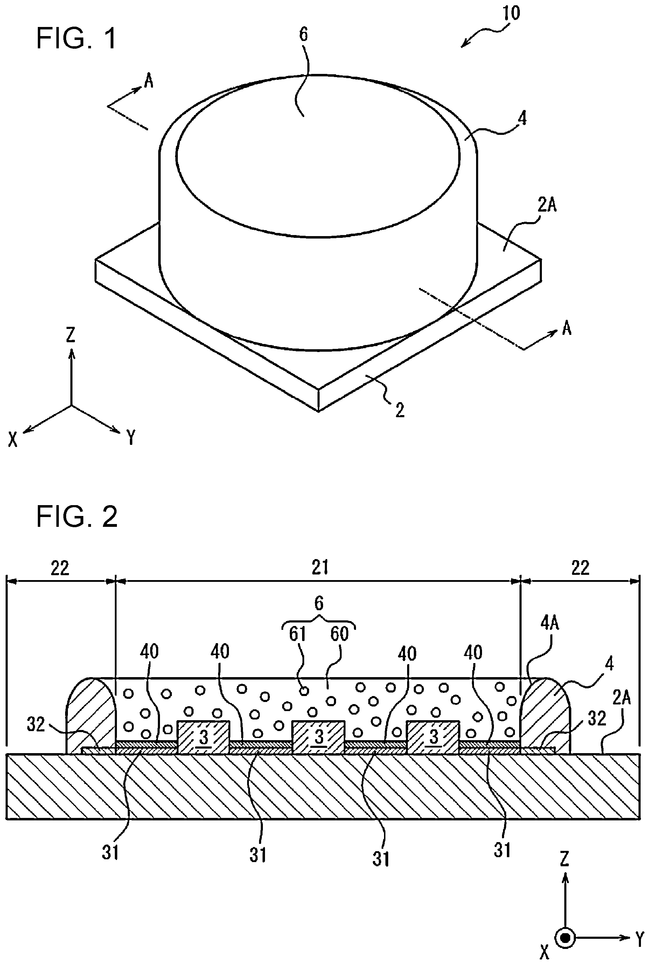

As illustrated in FIG. 1, FIG. 2, FIG. 3, and FIG. 4, a light emitting device 10 includes an element substrate 2, a light emitting element 3, and a wavelength conversion member 6. The light emitting device 10 may further include a frame member 4. The light emitting element 3 is mounted on the element substrate 2. The wavelength conversion member 6 is disposed on the light emitting element 3. Light emitted by the light emitting element 3 is converted by the wavelength conversion member 6 and emitted from the light emitting device 10.

The light emitting element 3 emits light having a peak wavelength in the 360 nm to 430 nm wavelength range. The 360 nm to 430 nm wavelength range is also referred to as the violet light range.

The wavelength conversion member 6 converts light emitted by the light emitting element 3 and entering the wavelength conversion member 6, into light having a peak wavelength in the 360 nm to 780 nm wavelength range, and emits the resulting light. The 360 nm to 950 nm wavelength range is also referred to as the visible light range. The visible light range includes the violet light range. Visible light includes violet light. By being excited by light emitted from the light emitting element 3, the wavelength conversion member 6 emits light having a peak wavelength in the visible light range. Light emitted by the light emitting element 3 is also referred to as exciting light. The light emitting element 3 included in the light emitting device 10 is also referred to as an exciting light emitting element.

Each component of the light emitting device 10 will now be described.

The element substrate 2 is also simply referred to as a substrate. The element substrate 2 may be made of, for example, an insulating material. The element substrate 2 may be made of, for example, a ceramic material, such as aluminum oxide (alumina) or mullite, a glass-ceramic material, or a composite including a mixture of more than one of these materials. The element substrate 2 may be made of a polymeric resin material in which fine particles of metal oxide with adjustable thermal expansion are dispersed. The element substrate 2 may include aluminum nitride or silicon carbide. This can improve thermal conductivity of the element substrate 2 and improve heat dissipation performance of the light emitting device 10.

The element substrate 2 has an upper surface 2A facing the positive direction of the Z axis. The light emitting element 3 is mounted on the upper surface 2A of the element substrate 2. The element substrate 2 has a first line 31 on the upper surface 2A. The first line 31 is for electrical connection of components, including the light emitting element 3. The first line 31 may be made of a conductive material, such as tungsten, molybdenum, manganese, or copper. For example, the first line 31 may be formed by printing a predetermined pattern, with a metal paste obtained by adding organic solvent to tungsten powder, onto a plurality of ceramic green sheets for forming the element substrate 2, and firing a laminate of the ceramic green sheets. As a surface layer for protection against oxidation, the first line 31 may include a plating layer of, for example, nickel or gold. The first line 31 is also referred to as a feed line.

The element substrate 2 further has a reflective layer 40 on the first line 31. The reflective layer 40 is disposed on the first line 31 and covers at least part of the first line 31. For example, the reflective layer 40 may be made of a material obtained by adding a white material, such as titanium oxide, to a silicone resin-based material. The reflective layer 40 is not limited to this example, and may be formed to have a higher reflectance than the first line 31. With the reflective layer 40 disposed on the first line 31, it is difficult for the first line 31 to absorb exciting light emitted from the light emitting element 3 and also to absorb illuminating light produced by conversion in the wavelength conversion member 6. This allows efficient emission of the exciting light and the illuminating light to the outside of the light emitting device 10.

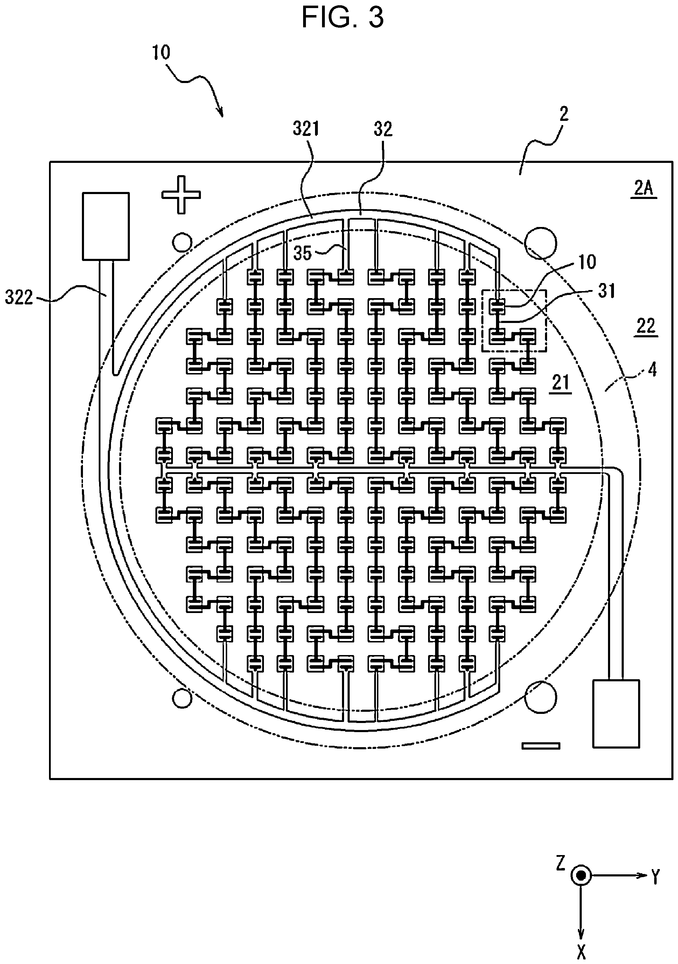

As illustrated in FIG. 3, the upper surface 2A of the element substrate 2 includes a first region 21 where the first line 31 is disposed, and a second region 22 around the first region 21. Although the first region 21 has a circular shape in the present embodiment, it may have various other shapes. The element substrate 2 further has a second line 32 disposed in the second region 22 of the upper surface 2A. The second line 32 electrically connects an external power supply to feed pads 33. The second line 32 includes a first portion 321 disposed around the first region 21 where the first line 31 is disposed, and a second portion 322 extending from the first portion 321 to connect to the external power supply. The first line 31 and the second line 32 are also collectively referred to as a feed line. That is, the feed line may include the first line 31 and the second line 32. The reflective layer 40 may be disposed on the second line 32 and cover at least part of the second line 32. The feed line may include a third line 35 configured to connect the second line 32 to the feed pads 33, as well as the first line 31 connecting the feed pads 33 together. The third line 35 is partially covered by the reflective layer 40. The third line 35 may be entirely covered, or partially exposed, by the reflective layer 40. The third line 35 is partially covered by a frame member 4 (described below).

In the present embodiment, the light emitting element 3 is a light emission diode (LED). The LED emits light to the outside when electrons and positive holes are recombined in a PN junction of a P-type semiconductor and an N-type semiconductor. The light emitting element 3 is not limited to an LED, and may be a light emitting device of other types.

The light emitting element 3 is mounted on the upper surface 2A of the element substrate 2. The light emitting element 3 is electrically connected to the feed pads 33, with, for example, brazing alloy or solder therebetween. The feed pads 33 are disposed on the upper surface 2A of the element substrate 2 and electrically connected to the first line 31. The light emitting element 3 is disposed on the feed pads 33 and at least partially covers the feed pads 33 in see-through plan view of the upper surface 2A of the element substrate 2. The feed pads 33 may be made of the same material as, or a material similar to, the first line 31. The feed pads 33 may be formed integrally with the first line 31. In this case, the light emitting element 3 may be greater than the feed pads 33 in see-through plan view.

The feed pads 33 are arranged in pairs and are connected to respective positive and negative electrodes of the light emitting element 3. For example, the feed pads 33 may have a greater width than other parts. The first line 31 electrically connects the positive electrode of the feed pad 33 in one pair to the negative electrode of the feed pad 33 in another pair. When the light emitting element 3 is mounted on the feed pads 33, the light emitting element 3 is electrically connected in series to another light emitting element 3 by the first line 31. A plurality of light emitting elements 3 is thus connected in series to produce a series electric circuit. The first line 31 is disposed to allow a plurality of series electric circuits to be formed on the element substrate 2. The series electric circuits are each connected at both ends thereof to the second line 32, so that they can receive supply of power from the power supply. That is, the series electric circuits are electrically connected in parallel between opposite sides of the second line 32.

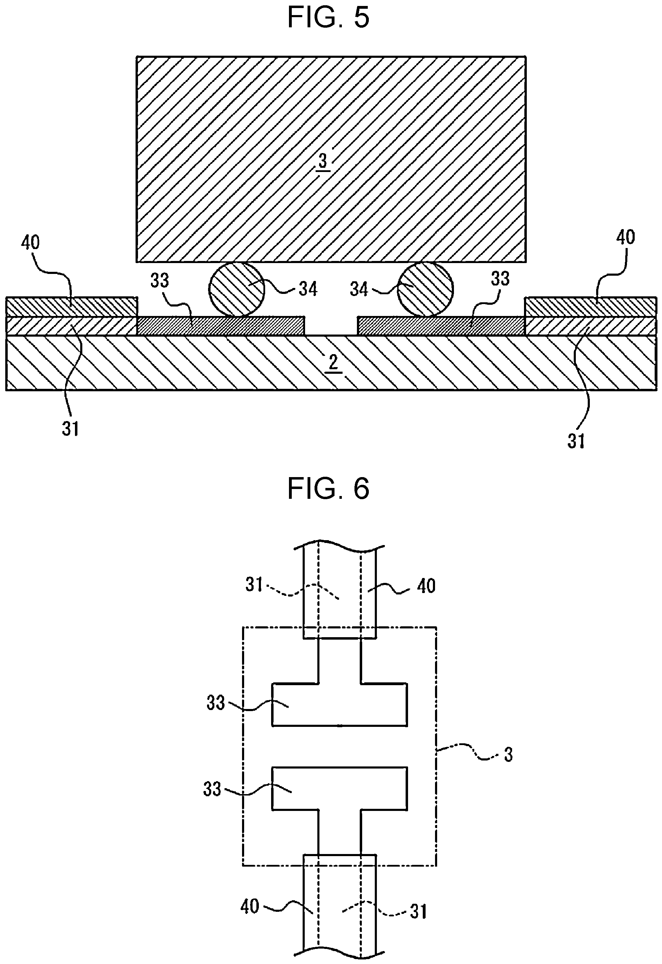

As illustrated in FIG. 5, the light emitting element 3 may be mounted on, and electrically connected to, the feed pads 33 on the element substrate 2, with a solder material 34, such as solder balls or solder paste, interposed between the light emitting element 3 and the feed pads 33. That is, the light emitting element 3 may be mounted to the element substrate 2 by flip chip bonding. When the light emitting element 3 is mounted by flip chip bonding, the solder material 34 for electrical connection to the feed pads 33 is covered by the light emitting element 3 in plan view of the upper surface 2A of the element substrate 2. When the solder material 34 is covered by the light emitting element 3, it is difficult for exciting light emitted from the light emitting element 3, or illuminating light produced by conversion in the wavelength conversion member 6, to enter the solder material 34. This makes it difficult for the element substrate 2 to absorb the exciting light or illuminating light, and thus can further improve light emitting efficiency of the light emitting device 10.

When the light emitting element 3 is mounted by wire bonding to the element substrate 2 in a comparative example, the wire is at least partially not covered by the light emitting element 3. In this case, exciting light or illuminating light may be absorbed by the wire. In the light emitting device 10 of the present embodiment, where the light emitting element 3 is mounted by flip chip bonding to the element substrate 2, it is more difficult for exciting light or illuminating light to be absorbed than in the comparative example where the light emitting element 3 is mounted by wire bonding. The light emitting device 10 can thus achieve higher light emitting efficiency.

Although three light emitting elements 3 are mounted on the upper surface 2A of the element substrate 2 in FIG. 2, the number of light emitting elements 3 is not particularly limited. There may be either less than, or more than, three light emitting elements 3. In plan view of the upper surface 2A of the element substrate 2, the light emitting elements 3 are disposed inside the frame member 4. When two or more light emitting elements 3 are mounted, the light emitting elements 3 are arranged so as not to overlap each other in plan view of the upper surface 2A.

The light emitting elements 3 each may include a light transmissive substrate and an optical semiconductor layer formed on the light transmissive substrate. The light transmissive substrate includes a material on which an optical semiconductor layer can be grown by chemical vapor deposition, such as metal-organic chemical vapor deposition or molecular beam epitaxy. The light transmissive substrate may be made of, for example, sapphire, gallium nitride, aluminum nitride, zinc oxide, zinc selenide, silicon carbide, silicon (Si), or zirconium diboride. The light transmissive substrate may have a thickness of, for example, greater than or equal to 50 µm and less than or equal to 1000 µm.

The optical semiconductor layer may include a first semiconductor layer formed on the light transmissive substrate, a light transmitting layer formed on the first semiconductor layer, and a second semiconductor layer formed on the light transmitting layer. The first semiconductor layer, the light transmitting layer, and the second semiconductor layer may be made of a group-III nitride semiconductor, a group III-V semiconductor, such as gallium phosphide or gallium arsenide, or a group-III nitride semiconductor, such as gallium nitride, aluminum nitride, or indium nitride.

The first semiconductor layer may have a thickness of, for example, greater than or equal to 1 µm and less than or equal to 5 µm. The light transmitting layer may have a thickness of, for example, greater than or equal to 25 nm and less than or equal to 150 nm. The second semiconductor layer may have a thickness of, for example, greater than or equal to 50 nm and less than or equal to 600 nm.

The frame member 4 may be made of a ceramic material, such as aluminum oxide, titanium oxide, zirconium oxide, or yttrium oxide. The frame member 4 may be made of a porous material. The frame member 4 may be made of a resin material obtained by mixing powders containing metal oxide, such as aluminum oxide, titanium oxide, zirconium oxide, or yttrium oxide. The frame member 4 may be made of various materials other than those described above.

The frame member 4 may be connected to the upper surface 2A of the element substrate 2 by resin, brazing alloy, or solder interposed therebetween, or by using adhesive properties of the frame member 4. The frame member 4 is disposed on the upper surface 2A of the element substrate 2 and surrounds the light emitting elements 3 at a distance therefrom. The internal surface of the frame member 4 functions as a reflective surface that reflects light emitted by the light emitting elements 3. The internal surface of the frame member 4 may include a metal layer made of a metal material, such as tungsten, molybdenum, or manganese, and a plating layer coating the metal layer and made of a metal material, such as nickel or gold. The plating layer reflects light emitted by the light emitting elements 3.

In plan view, the internal surface of the frame member 4 may be along the end portion of the first region 21 in the upper surface 2A of the element substrate 2. In the present embodiment, the internal surface of the frame member 4 extends, in a circle, along the end portion of the first region 21. With the internal surface extending in a circle, light emitted from the light emitting elements 3 can be reflected upward, substantially uniformly, by the frame member 4. The frame member 4 may be disposed on the second region 22 of the upper surface 2A of the element substrate 2.

The frame member 4 has an upper surface 4A. The upper surface 4A includes a surface curved upward. With the upper surface 4A including the surface curved upward, illuminating light produced by conversion in the wavelength conversion member 6 can be easily directed upward (or in the positive direction of the Z axis).

The frame member 4 and the reflective layer 40 may include the same material. This can reduce a difference in refractive index between the frame member 4 and the reflective layer 40, and thus can reduce problems, such as refraction of light between the frame member 4 and the reflective layer 40. The frame member 4 may have a higher viscosity than the reflective layer 40. This makes it easier for the frame member 4 to hold the wavelength conversion member 6 in place. The viscosity can be identified, for example, by analysis of component concentrations, or measurement of viscoelasticity.

The frame member 4 may entirely cover the first portion 321 of the second line 32. This reduces the entry of exciting light or illuminating light into the second line 32, and makes it difficult for the second line 32 to absorb such light. The light emitting device 10 can thus achieve higher light emitting efficiency. Entirely covering the first portion 321 of the second line 32 may mean that part of the first portion 321 is not covered due to an error in joining the frame member 4. If this does not affect reflection of light from the light emitting elements 3, that is, for example, if part of the first portion 321 not covered by the frame member 4 absorbs light and the resulting decrease in the efficiency of light emission from the light emitting elements 3 is less than 3%, then the decrease can be within the margin of error.

On the upper surface 2A of the element substrate 2, a space surrounded by the internal surface of the frame member 4 is filled with the wavelength conversion member 6. In other words, the frame member 4 is in contact with, and surrounds, the wavelength conversion member 6. The upper surface of the wavelength conversion member 6 with which the space is filled, as described above, may be flush with the upper surface 4A of the frame member 4. The wavelength conversion member 6 encapsulates the light emitting elements 3 by filling the space on the light emitting elements 3. Exciting light emitted from the light emitting elements 3 directly enters the wavelength conversion member 6. The wavelength conversion member 6 converts the exciting light (violet light) into light having a peak wavelength in the 360 nm to 780 nm wavelength range and emits the resulting light.

The wavelength conversion member 6 may include a light transmissive member 60 with light transmittance and a phosphor 61.

The light transmissive member 60 may be made of an insulating resin material having light transparency, such as fluorocarbon resin, silicone resin, acrylic resin, or epoxy resin, or may be made of a glass material having light transparency. A refractive index of the light transmissive member 60 may be set to, for example, greater than or equal to 1.4 and less than or equal to 1.6.

The phosphor 61 is contained in the light transmissive member 60. The phosphor 61 may be substantially uniformly dispersed in the light transmissive member 60. Violet light entering the light transmissive member 60 is converted by the phosphor 61 into light having various peak wavelengths.

The phosphor 61 may convert violet light into light identified, for example, by a spectrum having a peak wavelength in the 400 nm to 500 nm wavelength range, that is, into blue light. In this case, the phosphor 61 may include a material, such as BaMgAl₁₀O₁₇:Eu, (Sr,Ca,Ba)₁₀(PO₄)₆Cl₂:Eu, or (Sr,Ba)₁₀(PO₄)₆Cl₂:Eu.

The phosphor 61 may convert violet light into light identified, for example, by a spectrum having a peak wavelength in the 450 nm to 550 nm wavelength range, that is, into blue-green light. In this case, the phosphor 61 may include a material, such as (Sr,Ba,Ca)₅(PO₄)₃Cl:Eu or Sr₄Al₁₄O₂₅:Eu.

The phosphor 61 may convert violet light into light identified, for example, by a spectrum having a peak wavelength in the 500 nm to 600 nm wavelength range, that is, into green light. In this case, the phosphor 61 may include a material, such as SrSi₂(O,Cl)₂N₂:Eu, (Sr,Ba,Mg)₂SiO₄:Eu²⁺, ZnS:Cu,Al, or Zn₂SiO₄:Mn.

The phosphor 61 may convert violet light into light identified, for example, by a spectrum having a peak wavelength in the 600 nm to 700 nm wavelength range, that is, into red light. In this case, the phosphor 61 may include a material, such as Y₂O₂S:Eu, Y₂O₃:Eu, SrCaClAlSiN₃:Eu²⁺, CaAlSiN₃:Eu, or CaAlSi(ON)₃:Eu.

The phosphor 61 may convert violet light into light identified, for example, by a spectrum having a peak wavelength in the 680 nm to 800 nm wavelength range, that is, into near-infrared light. The near-infrared light may include light having a wavelength in the 680 nm to 2500 nm wavelength range. In this case, the phosphor 61 may include a material, such as 3Ga₅O₁₂:Cr.

The combination of types of the phosphor 61 included in the wavelength conversion member 6 is not particularly limited. The phosphor 61 may include various materials other than those described above.

As described above, violet light entering the wavelength conversion member 6 from the light emitting elements 3 is converted by the phosphor 61 into light having different peak wavelengths. The peak wavelengths of the light produced by the conversion can be included in the visible light range. The light produced by the conversion can have a plurality of peak wavelengths depending on the combination of types of the phosphor 61 included in the wavelength conversion member 6. For example, when the phosphor 61 includes a material emitting blue fluorescence, a material emitting blue-green fluorescence, and a material emitting green fluorescence, then the light produced by the conversion has the wavelengths of blue, blue-green, and green light as peak wavelengths. When the phosphor 61 includes only one type of material, the light produced by the conversion has the peak wavelength of the material. The phosphor 61 may include various combinations of materials and is not limited to the examples described above. The color of light emitted from the wavelength conversion member 6 is determined on the basis of the type of material included in the phosphor 61. That is, the light produced by the conversion can have various spectra.

In the present embodiment, the light emitting device 10 can emit light with various spectra depending on the combination of materials included in the phosphor 61. For example, the light emitting device 10 can emit light having a spectrum of direct sunlight, a spectrum of sunlight reaching a predetermined depth in the sea, a spectrum of candle flame, or a spectrum of firefly's light. In other words, the light emitting device 10 can emit light of various colors. Also, the light emitting device 10 can emit light with various color temperatures.

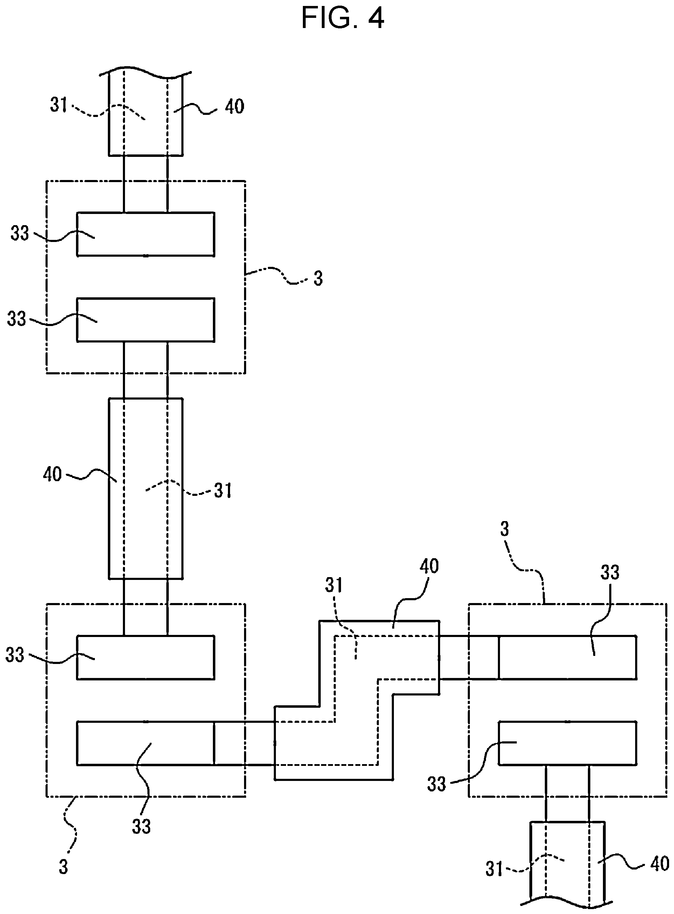

As illustrated in FIG. 4, in plan view of the upper surface 2A of the element substrate 2, the reflective layer 40 covers at least part of the first line 31. The reflectance of exciting light emitted from the light emitting elements 3, or of illuminating light produced by conversion in the wavelength conversion member 6, off the reflective layer 40 is higher than the reflectance of the exciting light or illuminating light off the first line 31. This makes it difficult for the exciting light or illuminating light to be absorbed when entering the upper surface 2A, and allows the exciting light or illuminating light to easily reflect off the reflection upper surface 2A and travel upward from the light emitting device 10. The light emitting device 10 can thus achieve higher light emitting efficiency.

In plan view of the upper surface 2A of the element substrate 2, the light emitting elements 3 each cover the feed pads 33 electrically connected thereto. Here, covering may mean, for example, that the light emitting element 3 covers greater than or equal to 80% of the feed pads 33. In other words, the feed pads 33 are covered by the light emitting element 3. The feed pads 33, which are electrically connected to the light emitting element 3, are not covered by the reflective layer 40 in principle. Covering the feed pads 33 with the light emitting element 3 reduces entry of the exciting light or illuminating light into the feed pads 33. When entry of light into the feed pads 33 is reduced, exciting light or illuminating light is not easily absorbed by the feed pads 33. This can further improve light emitting efficiency of the light emitting device 10.

As illustrated in FIG. 6, the reflective layer 40 may entirely cover the first line 31. This reduces the entry of exciting light or illuminating light into the first line 31. When entry of light is reduced, light is not easily absorbed by the first line 31. This can further improve light emitting efficiency of the light emitting device 10. Note that entirely covering the first line 31 may mean that part of the first line 31 is not covered due to an error in forming the reflective layer 40. If this does not affect reflection of light from the light emitting element 3, that is, for example, if part of the first line 31 not covered by the reflective layer 40 absorbs light and the resulting decrease in the efficiency of light emission from the light emitting element 3 is less than 3%, then the decrease can be within the margin of error.

In see-through plan view of the upper surface 2A of the element substrate 2, the light emitting element 3 may be disposed on the feed pads 33 and entirely cover the feed pads 33. This makes it more difficult for the exciting light or illuminating light to enter the feed pads 33. When entry of light is reduced, light is not easily absorbed by the feed pads 33. This can further improve light emitting efficiency of the light emitting device 10. Here, entirely covering the feed pads 33 may mean that the feed pads 33 are partially not covered due to an error in mounting the light emitting element 3. For example, the light emitting element 3 may cover greater than or equal to 95% of the feed pads 33. If this does not affect reflection of light from the light emitting element 3, that is, for example, if part of the feed pads 33 not covered by the light emitting element 3 absorbs light and the resulting decrease in the efficiency of light emission from the light emitting elements 3 is less than 3%, then the decrease can be within the margin of error.

In see-through plan view of the element substrate 2, the reflective layer 40 may cover part of a region overlapping the light emitting element 3. The reflective layer 40 may partially cover the feed pads 33 as long as electrical connection between the feed pads 33 and the light emitting element 3 is maintained. This makes it more difficult for the exciting light or illuminating light to enter the feed pads 33. When entry of light is reduced, light is not easily absorbed by the feed pads 33. This can further improve light emitting efficiency of the light emitting device 10.

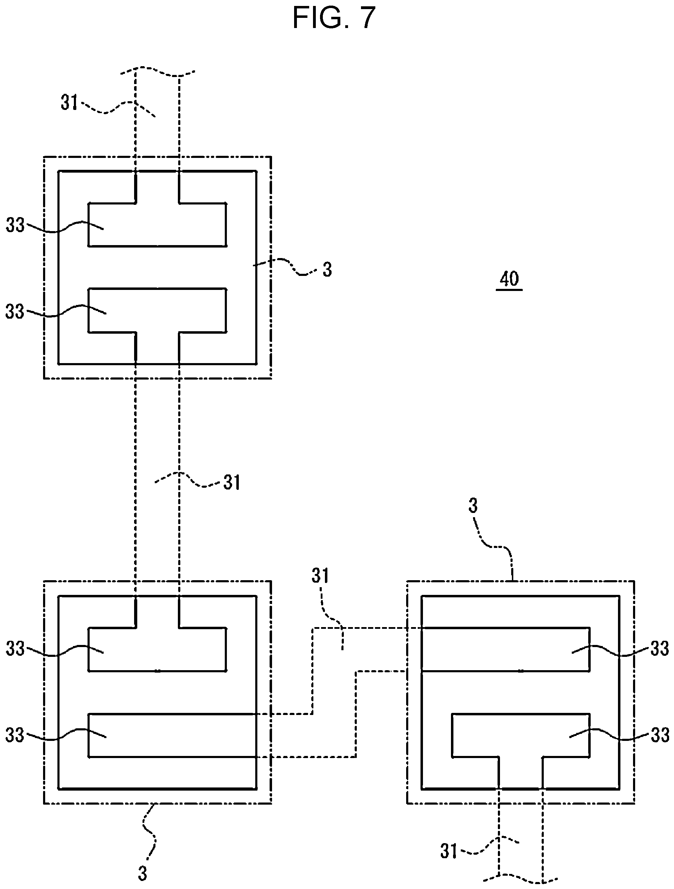

As illustrated in FIG. 7, the reflective layer 40 may cover the entire area not covered by the light emitting elements 3 in see-through plan view, in the first region 21 of the upper surface 2A of the element substrate 2. This can improve reflectance throughout the upper surface 2A of the element substrate 2, and thus can improve light emitting efficiency of the light emitting device 10.

In the first region 21 of the upper surface 2A of the element substrate 2, the reflective layer 40 may cover at least the entire area, except the area occupied by the feed pads 33. This can also improve reflectance throughout the upper surface 2A of the element substrate 2, and thus can improve light emitting efficiency of the light emitting device 10.

As described above, the light emitting device 10 can achieve higher light emitting efficiency in the present embodiment.

### (Exemplary configuration of illuminating apparatus 100)

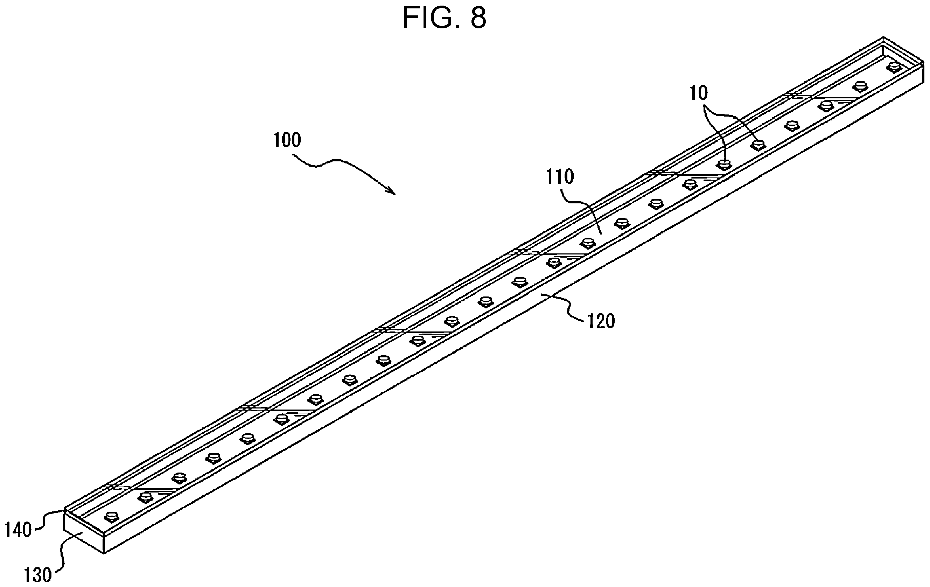

As illustrated in FIG. 8, in an embodiment, an illuminating apparatus 100 includes at least one light emitting device 10. Light emitted from the light emitting device 10 is emitted as illuminating light by the illuminating apparatus 100. When the illuminating apparatus 100 includes a plurality of light emitting devices 10, the illuminating apparatus 100 may control the intensities of light beams emitted from the light emitting devices 10, independently or in association with each other. The spectra of light beams emitted from the light emitting devices 10 may either be the same or different from each other. By controlling the intensities of light beams emitted from the light emitting devices 10 independently or in association with each other, the illuminating apparatus 100 may control the spectrum of light produced by combining the light beams emitted from the light emitting devices 10. The light produced by combining the light beams emitted from the light emitting devices 10 is also referred to as composite light. The illuminating apparatus 100 may emit the composite light as illuminating light. The illuminating apparatus 100 may select at least one of the plurality of light emitting devices 10 and emit illuminating light therefrom.

The illuminating apparatus 100 may further include a mount plate 110 on which the light emitting devices 10 are mounted. The illuminating apparatus 100 may further include a housing 120 with a groove for accommodating the mount plate 110, and a pair of end plates 130 that closes the end portions of the housing 120 on the short sides. The number of light emitting devices 10 mounted on the mount plate 110 may be one or more than one. The light emitting devices 10 may be mounted on the mount plate 110 in a row, in a grid, or in a staggered manner. The arrangement of the light emitting devices 10 is not limited to this. The light emitting devices 10 may be mounted on the mount plate 110 in various patterns of arrangement.

The mount plate 110 may include a circuit board having a wiring pattern thereon. The circuit board may be a printed substrate, such as a rigid substrate, a flexible substrate, or a rigid flexible substrate. The circuit board may include a driving circuit configured to control the light emitting devices 10.

The mount plate 110 has the function of dissipating heat generated by the light emitting devices 10. The mount plate 110 may be made of a metal material, such as aluminum, copper, or stainless steel, an organic resin material, or a composite of these materials.

The mount plate 110 may have an elongated rectangular shape in plan view. The shape of the mount plate 110 is not limited to this, and may be various other shapes.

The illuminating apparatus 100 may further include a lid 140 configured to enclose the mount plate 110 and the light emitting devices 10 contained in the housing 120. The lid 140 may be made of a light transmitting material, so as to allow illuminating light emitted from the light emitting devices 10 to pass therethrough to the outside of the illuminating apparatus 100. The lid 140 may be made of a resin material, such as acrylic resin, or glass. The lid 140 may have an elongated rectangular shape in plan view. The shape of the lid 140 is not limited to this, and may be various other shapes. The illuminating apparatus 100 may further include a sealing member between the lid 140 and the housing 120. This makes it difficult for water or dust to enter the housing 120, and improves reliability of the illuminating apparatus 100, regardless of the environment where the illuminating apparatus 100 is installed. The illuminating apparatus 100 may further include a moisture absorbent inside the housing 120.

The drawings for describing the embodiments of the present disclosure are schematic ones. The dimensional ratios in the drawings are not necessarily the same as actual ones.

Although embodiments of the present disclosure have been described on the basis of drawings and examples, the present disclosure is not limited to the embodiments described above. It is to be noted that various alternative embodiments or changes can be made on the basis of the present disclosure by any person skilled in the art. Therefore, it is to be noted that such alternative embodiments or changes are included in the scope of the present disclosure. For example, functions included in each component can be rearranged in a logically non-contradictory way. A plurality of components may be combined into a single one, or may each be divided into sub-components. Various other changes can be made without departing from the spirit of the present disclosure. For example, the internal wall of the frame member 4 has been described as not being inclined in the embodiments of the present disclosure. Depending on the size of the light emitting device 10, however, the internal surface of the frame member 4 may be inclined outward as it extends away from the upper surface 2A of the element substrate 2. In this case, the internal surface functions as a reflective surface that reflects light emitted by the light emitting elements 3.

In the present disclosure, the terms such as "first" and "second" are identifiers used to distinguish different components. In the present disclosure, the ordinal numbers, such as "first" and "second", assigned as identifiers to components are interchangeable. For example, "first" and "second" of the first converted light and the second converted light are interchangeable. The identifiers are interchanged at the same time. The components are distinguishable even after the identifiers are interchanged. The identifiers may be deleted. Without the identifiers, the components are distinguished with symbols. In the present disclosure, identifiers, such as "first" and "second", are not to be used to interpret the order of the components, or as a basis for the presence of identifiers with smaller ordinal numbers.

In the present disclosure, the X axis, the Y axis, and the Z axis are provided for convenience of explanation, and are interchangeable. In the present disclosure, components have been described using a rectangular coordinate system defined by the X axis, the Y axis, and the Z axis. In the present disclosure, the positional relations of components may not necessarily be orthogonal.

### REFERENCE SIGNS

- 10: light emitting device
- 2: element substrate (2A: upper surface, 21: first region, 22: second region)
- 3: light emitting element
- 4: frame member
- 6: wavelength conversion member (60:light transmissive member, 61:phosphor)
- 31: first line
- 32: second line (321: first portion, 322: second portion)
- 33: feed pad
- 34: solder material
- 35: third line
- 40: reflective layer
- 100: illuminating apparatus (110: mount plate, 120:housing, 130: end plate, 140: lid)

## Claims

1. A light emitting device comprising:
a substrate on which a feed line and a feed pad are electrically connected to each other;
a reflective layer disposed on the feed line and configured to cover at least part of the feed line;
a light emitting element electrically connected to the feed line, with the feed pad therebetween, the light emitting element being configured to emit exciting light; and
a wavelength conversion member disposed on the light emitting element and configured to convert the exciting light into illuminating light,
wherein the light emitting element is disposed on the feed pad electrically connected to the light emitting element, and covers the feed pad in see-through plan view of the substrate.

2. The light emitting device according to claim 1, wherein the light emitting element is disposed on the feed pad and entirely covers the feed pad in see-through plan view of the substrate.

3. The light emitting device according to claim 1 or 2, wherein the reflective layer covers part of a region overlapping the light emitting element in see-through plan view of the substrate.

4. The light emitting device according to any one of claims 1 to 3, wherein the substrate comprises a first region and a second region disposed around the first region, and the feed pad is disposed in the first region; and
the feed line comprises a first line disposed in the first region and electrically connected to the feed pad.

5. The light emitting device according to claim 4, wherein the reflective layer entirely covers the first line.

6. The light emitting device according to claim 4 or 5, wherein the reflective layer entirely covers at least the first region, except the feed pad.

7. The light emitting device according to any one of claims 4 to 6, wherein the feed line further comprises a second line disposed in the second region; and
the reflective layer covers at least part of the second line.

8. The light emitting device according to any one of claims 4 to 7, further comprising a frame member disposed on the second region of the substrate, the frame member being configured to surround and be in contact with the wavelength conversion member.

9. The light emitting device according to claim 8, wherein an upper surface of the frame member comprises a curved surface.

10. The light emitting device according to claim 8 or 9, wherein the frame member and the reflective layer comprise a same material; and
the frame member has a higher viscosity than the reflective layer.

11. The light emitting device according to any one of claims 8 to 10, wherein the feed line further comprises a second line disposed in the second region;
the second line comprises a first portion disposed around the first region, and a second portion extending from the first portion to an external power supply; and
the frame member entirely covers the first portion.

12. The light emitting device according to any one of claims 1 to 11, wherein the light emitting element is mounted by flip chip bonding to the substrate.

13. An illuminating apparatus comprising at least one light emitting device according to any one of claims 1 to 12.
